# EUROPÄISCHE PATENTSCHRIFT

(11) **EP 3 351 071 B1**
(45) Veröffentlichungstag und Bekanntmachung des Hinweises auf die Patenterteilung: **25.09.2019**
(21) Anmeldenummer: 16808940.7
(22) Anmeldetag: 25.11.2016
(51) Int. Cl.: H05K 7/14

(54) **STROMSCHIENENANORDNUNG**
POWER LINE ASSEMBLY
AGENCEMENT DE RAILS CONDUCTEURS

(30) Priorität: 22.12.2015 EP 15201849
(43) Veröffentlichungstag der Anmeldung: 25.07.2018
(73) Patentinhaber: Siemens Aktiengesellschaft, 80333 München (DE)
(72) Erfinder: BÖHMER, Jürgen, 90547 Stein (DE); KLEFFEL, Rüdiger, 91056 Erlangen (DE); KRAFFT, Eberhard Ulrich, 90419 Nürnberg (DE); NAGEL, Andreas, 90431 Nürnberg (DE); WEIGEL, Jan, 91077 Großenbuch (DE)
(86) Internationale Anmeldenummer: PCT/EP2016/078864
(87) Internationale Veröffentlichungsnummer: WO 2017/108333

(56) Entgegenhaltungen:
- EP-A2- 2 493 043
- DE-A1-102004 060 583
- US-A1- 2010 089 641
- US-A1- 2013 187 453
- US-A1- 2013 271 941

## Beschreibung

Die Erfindung betrifft eine Stromschienenanordnung zur elektrischen Kontaktierung mindestens eines Halbleitermoduls, wobei die Stromschienenanordnung mindestens zwei Stromschienen aufweist, wobei zumindest in einem Überlappungsbereich der Stromschienenanordnung die Stromschienen sich gegenseitig überlappend angeordnet sind, wobei die Stromschienen elektrisch voneinander isoliert sind, wobei die Stromschienen jeweils mindestens einen Steg mit einem Anschlusselement aufweisen, wobei die Stege der Stromschienen überlappungsfrei angeordnet sind. Die Erfindung betrifft weiter ein Stromrichtermodul mit einer solchen Stromschienenanordnung, einem Halbleitermodul und mindestens einem Kondensator. Ferner betrifft die Erfindung die Verwendung einer solchen Stromschienenanordnung zur Verbindung mindestens eines Halbleitermoduls mit mindestens einem Kondensator.

Halbleiter benötigen aufgrund ihrer Fähigkeit, große Ströme schnell und oft schalten zu können eine niederinduktive Verbindung zu einem Kondensator. Dieser Kondensator wird auch als Zwischenkreiskondensator bezeichnet. Für die Herstellung der niederinduktiven Verbindung werden meistens Stromschienen eingesetzt. Dabei werden Stromrichter für hohe Leistungen typischerweise mit nebeneinander angeordneten, parallelgeschalteten Halbleitermodulen, kurz auch als Module bezeichnet, aufgebaut. Bei einer typische Anschlussgeometrie liegen die Gleichspannungsanschlüsse, auch als DC+/DC- Anschlüsse bezeichnet, nebeneinander an einer Seite des Moduls. Zur Eignung für hochdynamisch geschaltete Halbleiterchips ist eine kleine Induktivität im Modul, als auch im externen Kommutierungskreis unerlässlich. Diese Module bieten die Möglichkeit, eines modularen Stromrichteraufbaus, um durch Parallelschaltung an die Leistungsanforderungen oder durch unabhängige Lastverschaltung an die gewünschte Funktion (verschiedene Stromrichterphasen) anzupassen.

Dabei ist eine hochgradige Stromsymmetrie der parallelgeschalteten Halbleitermodule wünschenswert, da das am höchsten belastete Modul die Leistungsfähigkeit der Parallelschaltung bestimmt. Dabei soll die Leistungsfähigkeit eines Moduls möglichst unabhängig vom Belastungszustand der benachbarten, unabhängig betriebenen Module sein. Die nebeneinanderliegenden angeordneten Paare von Gleichspannungsanschlüssen, also der DC+ und der DC- Anschluss, sind zumeist mit einer gemeinsamen Zwischenkreisverschienung kontaktiert.

Aus der DE 10 2004 060 583 A1 ist eine Stromschiene und ein Stromschienenpaar für ein Flachmodul bekannt. Dort weist die Stromschiene mehrere Anschlusslaschen auf, die jeweils einen mit einer Bohrung versehenen Anschlussbereich aufweisen, wobei jede Anschlusslasche mittels eines Schlitzes aus einem Randbereich der Stromschiene und mittels zweier Abkantungen derart gebildet sind, dass deren Anschlussbereiche in einer zur Stromschiene parallelen Ebene nebeneinander beabstandet angeordnet sind. Somit wird die induktivitätsarme Flachverschienung der beiden Stromschienen bis in den Anschlussbereich des Flachmoduls fortgesetzt.

Aus der US 2010/0089641 A1 ist eine Sammelschienenanordnung für ein Wechselrichtermodul mit einem Leistungsmodul, einem Kondensatormodul mit mindestens einem Kondensator und einer Batterie bekannt, die alle diese Komponenten durch eine Sammelschiene miteinander verbindet. Die Stromschiene weist einen Basisabschnitt auf, der elektrisch mit der Batterie gekoppelt ist, und einem Zweigsammelschienenabschnitt, der sich von der Basisstromschiene zum Leistungsmodul erstreckt und dieses elektrisch mit dem Kondensatormodul an Punkten zwischen dem Basisknoten und dem Leistungsmodul verbindet.

Der Erfindung liegt die Aufgabe zugrunde, ein Verbindungselement zum Anschluss an ein Halbleitermodul anzugeben, das eine Wechselwirkung zwischen den Anschlüssen des Halbleitermoduls oder der Halbleitermodule reduziert und das eine geringe Dicke aufweist.

Die Aufgabe wird durch eine Stromschienenanordnung zur elektrischen Kontaktierung mindestens eines Halbleitermoduls gelöst, wobei die Stromschienenanordnung mindestens zwei Stromschienen aufweist, wobei zumindest in einem Überlappungsbereich der Stromschienenanordnung die Stromschienen sich gegenseitig überlappend angeordnet sind, wobei die Stromschienen elektrisch voneinander isoliert sind, wobei die Stromschienen jeweils mindestens einen Steg mit einem Anschlusselement aufweisen, wobei die Stege der Stromschienen überlappungsfrei angeordnet sind, wobei die Stege derart ausgerichtet sind, dass eine erste Achse gebildet werden kann, die durch das Anschlusselement des jeweiligen Stegs und einem Punkt eines Übergangs des jeweiligen Stegs zu dem Überlappungsbereich der Stromschienenanordnung verläuft, und die eine zweite Achse, die durch eine Verbindung zweier Anschlusselemente der Stege gebildet wird, in einem Winkel zwischen 0° und 45° schneidet, wobei die Stromschienenanordnung einen Isolierbereich aufweist, der derart angeordnet ist, einen Strom im Steg in einer Richtung senkrecht zur zweiten Achse zu reduzieren oder zu verhindern. Die Aufgabe wird weiter durch Stromrichtermodul mit einer solchen Stromschienenanordnung, mindestens einem Halbleitermodul und mindestens einem Kondensator gelöst, wobei das Halbleitermodul zwei Gleichspannungsanschlüsse aufweist, wobei die Gleichspannungsanschlüsse jeweils mit einem Anschlusselement der Stromschienenanordnung elektrisch verbunden sind, wobei der Kondensator zwei Elektroden aufweist, wobei die Stromschienen der Stromschienenanordnung jeweils mit einer Elektrode des Kondensators elektrisch verbunden sind. Ferner wird die Aufgabe durch eine Verwendung einer solchen Stromschienenanordnung zur Verbindung mindestens eines Halbleitermoduls mit mindestens einem Kondensator, insbesondere in einem Stromrichter, gelöst.

Vorteilhafte Ausgestaltungen der Erfindung sind in den abhängigen Ansprüchen angegeben.

Der Erfindung liegt die Erkenntnis zugrunde, dass sich die Wechselwirkung zwischen den Gleichspannungsanschlüssen eines Halbleitermoduls oder mehrerer Halbleitermodule dadurch reduzieren lässt, indem die magnetische Kopplung der Magnetfelder, die durch die Ströme an den Gleichspannungsanschlüssen erzeugt werden, reduziert wird. Diese können unter anderem durch die Ausbildung der Anschlusselemente der Stromschienenanordnung beeinflusst werden. Dafür sind verschiedene Anschlussgestaltungen vorstellbar, die jeweils Einschränkungen durch die Isolationsanforderungen zwischen den Gleichspannungspotentialen unterworfen sind. Gemeinsam ist jeweils die Funktion, einen Zwischenkreis mit einem Halbleitermodul oder mindestens zwei Halbleitermodulen zu kontaktieren, wobei sich Unterschiede im Nahbereich um die Module, insbesondere den Modulanschlüssen ergeben.

Dabei spannen die Strompfade in der Verschienung stets Schleifen auf, die Magnetfelder erzeugen und mit Fremdfeldern verkoppelt sind. Die Stromdichteverteilung in der Verschienung richtet sich im Wesentlichen nach den ohmschen und den induktiven Impedanzen und nach den geometrischen Zwangsbedingungen. Je kleiner die Frequenz, desto mehr stellen sich die Stromdichteverteilungen entsprechend der ohmschen Verluste ein. Je höher die Frequenz ist, desto mehr sucht der Hinstrom die Nähe des Rückstroms, um den Energieinhalt des Magnetfelds zu minimieren. Mit Hinstrom wird der Strom in einer der beiden Stromschienen bezeichnet. Der Rückstrom ist ein dem Hinstrom entgegengesetzter Strom in der jeweils anderen Stromschiene. Damit sich Hinstrom und Rückstrom möglichst gut kompensieren können, sind in dem Überlappungsbereich die Stromschienen parallel zueinander angeordnet. Der Abstand wird im Wesentlichen durch die Potenzialdifferenz der Stromschienen bestimmt. Es muss verhindert werden, dass es zu einem Überschlag zwischen den Stromschienen kommt. Um den Abstand möglichst gering zu halten und damit die Ausbildung entstehende Magnetfelder gering zu halten, hat es sich als vorteilhaft erwiesen, einen Isolator zwischen den Stromschienen anzuordnen. Dieser erlaubt den Abstand gering auszuführen.

Somit stellt der Überlappungsbereich keine wesentliche Quelle für ein Magnetfeld dar, da sich in diesem Bereich Hinstrom und Rückstrom kompensieren und sich damit einhergehende magnetische Felder ebenfalls kompensieren und keine koppelnde Wirkung erzeugen.

Der Überlappungsbereich ist der Bereich, in dem sich die beiden Stromschienen überlappen. Mit anderen Worten liegen diese Stromschienen in diesem Bereich je nach Betrachtungswinkel nebeneinander oder übereinander. Anders ausgedrückt liegt im Überlappungsbereich eine Stromschiene hinter der anderen Stromschiene wenn man aus einer Achse auf die Stromschienenanordnung blickt, die senkrecht auf der Stromschienenanordnung steht. Im Überlappungsbereich können die Stromschienen parallel angeordnet sein, was jedoch nicht unbedingt notwendig ist. Ebenso ist es möglich, in einem ersten Teil des Überlappungsbereichs die Stromschienen parallel anzuordnen und in einem zweiten Teil des Überlappungsbereichs, beispielsweise in der Nähe zum Übergang zwischen Steg und Überlappungsbereich nichtparallel anzuordnen. Somit kann insbesondere bei einer nichtparallelen Anordnung noch immer von einer überlappenden Anordnung ausgegangen werden, wenn bei einer nichtparallelen Anordnung der Stromschienen diese sich in einem Winkel von bis zu 90° schneiden.

Im Bereich der Anschlüsse können die Stromschienen meist nicht überlappend ausgeführt werden. Dieser Bereich ist somit überlappungsfrei. Der überlappungsfreie Bereich wird mittels eines Stegs gebildet. Die Stege weisen dabei jeweils mindestens ein Anschlusselement auf. Bei dem Anschlusselement kann es sich in einer einfachen Ausgestaltung um ein Loch handeln, das mittels einer Schraube einen elektrischen Kontakt zu dem Halbleitermodul herstelle kann. Die Stege sind dabei so ausgeführt, dass ein dadurch fließender Strom ein Magnetfeld erzeugt, dass nicht oder nur zu einem geringen Teil einen anderen Steg oder einen Anschluss, von dem der Steg elektrisch isoliert ist, durchdringt. Die Stege sind dabei so ausgerichtet, dass diese parallel zu einer Achse verlaufen, die durch die Anschüsse eines Halbleiters oder mehrerer Halbleiter gebildet wird. Unter Ausrichtung des Stegs wird die Ausrichtung der Verbindung von Anschlusselement zum Übergang zum Überlappungsbereich verstanden. In dieser Richtung fließt auch während des Betriebs im Wesentlichen der Strom. Auch eine Abweichung von bis zu 45° vom parallelen Verlauf, d.h. ein Winkelbereich von 0° bis 45°, bewirkt noch eine hinreichende Reduktion koppelnder Magnetfelder. Bei einem Stromfluss, der parallel zur zweiten Achse erfolgt ist im Idealfall die Kopplung vollständig beseitigt. Im oben angegebenen Winkelbereich ist die Kopplung allerdings bereits so gering, dass insbesondere ein Betrieb mit hohen Frequenzen, bei dem die Induktivitäten besonders stark wirken, bereits in vorteilhafter Weise möglich ist.

Da der Strom sich vom Anschlusselement zum Übergang im Steg auffächert, gibt es auch einen geringen Anteil des Stroms in Richtung senkrecht zur Ausrichtung des Stegs, der jedoch kleiner bzw. deutlich kleiner ist als der Anteil in Richtung parallel zur Ausrichtung des Stegs. Damit kann eine magnetische Kopplung der unterschiedlichen Anschlüsse eines oder mehrerer Halbleitermodule deutlich reduziert oder vollständig vermieden werden.

Durch die erfindungsgemäße Anordnung können unerwünschte magnetische Kopplungen zwischen den Anschlüssen, insbesondere den Gleichspannungsanschlüssen, benachbarter Module oder benachbarter Schaltkreise, beispielsweise unterschiedliche Halbbrücken, eines Moduls vermieden werden, die zu unterschiedlichen wirksamen Induktivitäten in den verschiedenen Stegen führen. Insbesondere bei hochdynamischen Schaltvorgängen würden diese ansonsten einerseits bei Parallelschaltung die Stromsymmetrie negativ beeinflussen. Andererseits führen sie zu unerwünschten Kopplungen im Schaltverhalten benachbarter, unabhängiger Module, deren Kommutierungsströme grundsätzlich unterschiedlich, sogar entgegengesetzt gleich groß sein können. Dies wird durch die erfindungsgemäße Stromschienenanordnung vermieden.

Es hat sich gezeigt, dass je niederinduktiver der Modulaufbau und je schneller die Stromänderung in den Anschlüssen, desto vorteilhafter wirkt sich die Stromschienenanordnung nach der Erfindung auf die Entkopplung der einzelnen Anschlüsse des Halbleitermoduls bzw. der Halbleitermodule aus. Darüber hinaus kann auch eine parasitäre Einkopplung von Magnetfeldern in Steuerkreise benachbarter elektronischer Schaltung deutlich vermindert werden, die ansonsten zu einem abhängigen Schaltverhalten verschiedener Module führen.

Die Stromschienenanordnung ist weitestgehend gemäß einer Streifenleitung aufgebaut, die Hin- und Rückstrom flächig in direkter Nähe führt. Wo das aus Isolationsgründen nicht möglich ist, wird die Geometrie dahingehend gestaltet, dass der Stromfluss in den Schienen keine Magnetfeldkomponenten erzeugt, die in benachbarte Anschlüsse einkoppeln. Die aufgespannte Fläche, in der durch parasitäre Magnetfelder eine Spannung induziert werden kann, wird auf ein Minimum reduziert. Dazu wird eine minimale Fläche zwischen den Schienen in den Ebenen parallel zum Abstand vorgesehen. Aufgrund geeigneter Geometrie der Stege wird eine magnetische Beeinflussung benachbarter Module durch Ströme, die nicht in Streifenleitung fließen, minimiert oder beseitigt.

Mit der Verschienung ergeben sich die Vorteile von einer minimalen Aussendung parasitärer Magnetfelder. Damit einher geht eine minimale Einkopplung parasitärer Magnetfelder in unerwünschten Bereichen. Dadurch wird sowohl im Leistungskreis als auch über die Steuerkreise die wechselseitige Beeinflussung von nebeneinander angeordneten Halbleitermodulen oder nebeneinander angeordneten Schaltkreisen eines Halbleitermoduls minimiert.

Für einen Stromrichter ergibt sich der Vorteil, dass mehrere Halbleitermodule, beispielsweise für unterschiedliche Phasen in enger räumlicher Nähe angeordnet werden können. Dadurch können diese Stromrichter besonders klein, leicht und kompakt hergestellt werden.

Es hat sich als vorteilhaft erwiesen, einen Isolierbereich in der Stromschienenanordnung anzuordnen. Die Isolierbereiche sind nichtleitende Bereiche in der Stromschienenanordnung. Anders ausgedrückt, sind dies Bereiche, in der Stromschienenanordnung, in der keine Stromschiene vorhanden ist bzw. auf die sich die Stromschienen nicht erstrecken. Diese können beispielsweise auf einfache Weise durch die Wegnahme des Materials der Stromschiene realisiert werden. So kann die Stromschiene beispielsweise Ausnehmungen, Ausschnitte oder Löcher (rund, rechteckig oder als Langloch) aufweisen, die dazu führen, dass der Stromverlauf in der Stromschiene, insbesondere im Steg beeinflusst wird. So können beispielsweise in einer Kupferstromschiene Ausnehmungen, Löcher oder Ausschnitte, beispielsweise rechteckig, vorhanden sein, die einen Stromfluss in diesem Bereich und/oder in einer bestimmten Richtung verhindern oder zumindest reduzieren. Auch eine räumlich getrennte Anordnung von Teilen der Stromschiene, bei der Luft in der Trennung zwischen den Teilen der Stromschiene vorhanden ist, kann als Isolierbereich angesehen werden. Mit Hilfe des Isolierbereichs ist es möglich, den Strom in dem Steg derart zu führen, dass er parallel zu der zweiten Achse verläuft. Bei der zweiten Achse handelt es sich um eine Achse, die durch eine Verbindung zweier Anschlusselemente der Stege gebildet wird. Damit entspricht diese Achse der Achse, die durch die Anschlüsse eines Halbleitermoduls oder durch die Anschlüsse verschiedener Halbleitermodule gebildet wird. Somit kann auf einfache und kostengünstige Weise ein Stromfluss in einer Richtung verhindert werden, der ein Magnetfeld erzeugt, das auf die anderen Anschlüsse koppelnd wirkt. Durch die Ausrichtung der Stege ist ein Stromfluss im Steg derart möglich, dass ein koppelndes Magnetfeld verhindert wird. Zusätzlich wird durch das Einbringen eines Isolierbereichs ein Stromfluss im Steg verhindert, der zu einem koppelnden Magnetfeld führen kann. Dies ist ein Magnetfeld, das andere Stege der Stromschienenanordnung schneidet.

Der Isolierbereich der Stromschienenanordnung kann dabei in der Umgebung des Stegs oder in der Umgebung des Überlappungsbereichs angeordnet sein. Darüber hinaus ist es möglich, mehrere Isolierbereiche in der Stromschienenanordnung anzuordnen. Auch kann sich der Isolierbereich auf Bereiche erstrecken, die in der Umgebung von Steg und Überlappungsbereich liegen.

Bei einer vorteilhaften Ausgestaltung der Erfindung sind die Stege derart ausgerichtet, dass eine weitere erste Achse gebildet werden kann, die durch das Anschlusselement des jeweiligen Stegs und einem Punkt des Übergangs des jeweiligen Stegs zu dem Überlappungsbereich der Stromschienenanordnung verläuft, und die zu der zweite Achse parallel oder im Wesentlichen verläuft. Im Wesentlichen parallel heißt in diesem Zusammenhang, dass der unterschiedliche Abstand zum Gleichspannungsanschluss des Halbleitermoduls vernachlässigt wird. Aufgrund der überlappenden Anordnung ergibt sich dieser Abstand, da eine Stromschiene etwas weiter von einem der Gleichspannungsanschlüsse entfernt ist als die andere. Je nach Größe des Stegs kann somit ein Winkel von bis zu 10° oder bis zu 20°, der durch den Abstand der Stromschienen voneinander entsteht, zwischen weiterer ersten Achse und zweiten Achse noch als im Wesentlichen parallel angesehen werden.

Durch diese Ausgestaltung ist unter anderem auch der Fall eingeschlossen, dass die Stege in einer Richtung ausgerichtet sind, die der Verbindung der Anschlüsse des Halbleitermoduls und/oder der Halbleitermodule entspricht. Darüber hinaus schließt diese Ausgestaltung den Fall ein, dass sich der Überlappungsbereich und die Stege jeweils in einer Ebene befinden. Damit lässt sich eine Stromschienenanordnung und die entsprechenden Stromschienen auf besonders einfache Weise fertigen. Die Ausrichtung der Stege in einer Richtung parallel zu einer Achse, die durch die Anschlüsse der Halbleitermodule gebildet wird, verursacht keine oder zumindest nur eine geringe Wechselwirkung eines Stroms eines Anschlusses des Halbleitermoduls auf einen anderen Anschluss des Halbleitermoduls oder eines anderen Halbleitermoduls. Die Achse, die durch die Anschlüsse der Halbleitermodule gebildet wird, entspricht im Allgemeinen der Achse, die durch eine Verbindung zweier Anschlusselemente der Stege gebildet wird.

Da sich die magnetischen Feldlinien näherungsweise kreisförmig um die Stege ausbilden, wenn die Stege von Strom durchflossen werden, ist an den übrigen Anschlüssen des Halbleitermoduls und/oder an den Anschlüssen der übrigen Halbleitermodulen kein Magnetfeld vorhanden, das durch diesen Strom gebildet wird. Wenn überhaupt können sich lediglich Streufelder aufgrund Unregelmäßigkeiten ergeben, die jedoch nur von geringer Größe sind.

Unter der Richtung eines Stegs versteht man die Achse, die sich aus dem Anschlusspunkt des Stegs und dem Übergang vom Steg zum Überlappungsbereich ergibt. Die Richtung des Stegs entspricht im Wesentlichen der Richtung des Stroms, der durch diesen Steg fließt.

Bei einer weiteren vorteilhaften Ausgestaltung der Erfindung ist der Isolierbereich derart angeordnet, die Ausbildung eines Stromes im Übergang zwischen Steg und Überlappungsbereich in Richtung senkrecht zur zweiten Achse zu reduzieren oder zu verhindern. Es hat sich als vorteilhaft erwiesen, die Stege dadurch herzustellen, dass aus einem leitenden Material wie beispielsweise Kupfer, im Bereich der Anschlusselemente einen Isolierbereich vorzusehen und damit dem Strom im Steg vom Anschlusselement zum Überlappungsbereich eine Richtung vorgeben zu können. Dabei ist der Isolierbereich in vorteilhafter Weise in einem Bereich angeordnet, der zwischen Steg und Überlappungsbereich liegt und die Ausbildung eines Stroms verhindert, der zu einer Achse, die durch die Anschlüsse des Halbleitermoduls oder der Halbleitermodule gebildet wird, senkrecht verläuft. Darüber hinaus hat es sich als günstig erwiesen, durch den Isolierbereich Ströme zu verhindern die eine Achse, die durch die Anschlüsse des Halbleitermoduls oder der Halbleitermodule gebildet wird, in einem Winkel größer als 45° schneidet. Als besonders vorteilhaft hat es sich erwiesen, Ströme zu verhindern, die nicht parallel zu einer Achse verlaufen, die durch die Anschlüsse des Halbleitermoduls oder der Halbleitermodule gebildet wird. Durch die Isolierbereiche lassen sich Stromschienen, insbesondere großflächige Stromschienen mit einer Fläche von mehr als 100 cm² auf einfache Weise aus einem leitenden Material wie beispielsweise Kupfer herstellen.

Darüber hinaus hat es sich in dieser Ausgestaltung der Erfindung als günstig erwiesen, wenn die Stege mindestens zwei Übergänge zu einem Überlappungsbereich aufweisen. Diese Übergänge können neben der Stromführung auch zum Fixieren, also zum Halten, der Stromschiene dienen. Es hat sich gezeigt, dass schon mit zwei Übergängen das Gewicht der Stromschiene durch die Übergänge zwischen Steg und Überlappungsbereich getragen werden können. Auf spezielle Halterungen, die gegebenenfalls noch dazu führen, dass die Halterung mechanisch überbestimmt ist, kann verzichtet werden. Durch die Überbestimmung reagiert die Halterung empfindlich auf Temperaturschwankungen, die im Betrieb der an der Stromschiene befindlichen Geräte und Anlagen entstehen. Durch die Halterung der Stromschiene über die Stege kann auf zusätzlich Halterungen verzichtet werden und die Anordnung ist bei thermischer Ausdehnung nicht überbestimmt, so dass hierdurch die Lebensdauer dieser Anordnung teilweise deutlich verbessert werden kann.

Bei einer weiteren vorteilhaften Ausgestaltung der Erfindung ist der Isolierbereich derart angeordnet, dass er sich an einem Überlappungsbereich anschließt. Hierbei handelt es sich um eine Ausgestaltungsform, wie ein Strom im Steg, senkrecht zur zweiten Achse verhindert werden kann. Dazu werden Ausnehmungen, d.h. Isolationsbereiche in der Umgebung des Überlappungsbereichs angeordnet. Es hat sich als besonders vorteilhaft erwiesen, wenn die Isolationsbereiche an mindestens zwei oder mindestens drei Seiten oder in Form eines Kreisausschnitts, insbesondere eines Halbkreises, an den Überlappungsbereich anschließt. Damit kann auf besonders einfache Weise ein derart wirksamer Isolationsbereich geschaffen werden, der einen Strom im Steg senkrecht zur zweiten Achse zuverlässig vermeidet oder zumindest deutlich reduziert.

Bei einer weiteren vorteilhaften Ausgestaltung der Erfindung ist der Isolierbereich abschnittsweise an einer Grenze zwischen Steg und Überlappungsbereich angeordnet ist. Damit wird an einer Grenze zwischen Steg und Überlappungsbereich die leitende Wirkung beseitigt, so dass in dieser Richtung kein Strom fließen kann. Diese Isolierung kann in vorteilhafter Weise dazu genutzt werden, einen Strom parallel zur zweiten Achse im Steg zu erzwingen, indem eine Komponente senkrecht zur zweiten Achse durch den Isolierbereich vermieden wird. Die Grenze zwischen Steg und Überlappungsbereich stellt somit kein Übergang zwischen Steg und Überlappungsbereich mehr dar, da ein Stromfluss von Steg zu Überlappungsbereich bzw. von Überlappungsbereich zum Steg nicht mehr möglich ist. Insbesondere die in den Figuren dargestellten und beschriebenen Ausführungsbeispiele zeigen einen Isolierbereich an der Grenze zwischen Steg und Überlappungsbereich.

Der Unterschiede zwischen Grenze und Übergang liegt darin, dass bei der Grenze an dieser Stelle kein leitender Übergang zwischen Steg und Überlappungsbereich vorhanden sein muss, sondern diese nur nahe beinander liegen. Gegebenenfalls kann, wie in diesem Ausführungsbeispiel, an der Grenze zwischen Steg und Überlappungsbereich zumindest abschnittsweise der Isolierbereich angeordnet sein.

Bei einer weiteren vorteilhaften Ausgestaltung der Erfindung sind zumindest zwei der Stege symmetrisch zueinander ausgebildet. Durch den symmetrischen Aufbau ergeben sich symmetrische Verhältnisse in Bezug auf die Magnetfelder. Insbesondere dann, wenn die Kopplung zu anderen Anschlüssen nicht komplett verhindert wird, kann durch den symmetrischen Aufbau sichergestellt werden, dass zumindest die Kopplung gleich oder zumindest überall nahezu gleich ist. So weisen die Anschlüsse des Halbleitermoduls bzw. der Halbleitermodule zumindest ein nahezu gleiches Verhalten auf.

Eine symmetrische Ausbildung zweier Stege bedeutet insbesondere, dass die zwei Stege symmetrisch zu einer Ebene, spiegelsymmetrisch, achsensymmetrisch oder punktsymmetrisch zueinander ausgeführt sind.

Die symmetrische Ausbildung der Stromschienen kann auf einfache Weise dadurch erreicht werden, dass zwei Stromschienen identisch ausgebildet sind, jedoch eine Stromschiene um 180° gedreht angeordnet sind. Der Fall der symmetrischen Stromschienen schließt auch die Ausgestaltung ein, dass die Stromschienen identisch ausgebildet sind, jedoch derart zueinander verschoben sind, dass die Anschlusselemente der jeweiligen Stromschienen sich an unterschiedlichen Punkten befinden. Dies hat den Vorteil, dass zum Aufbau der Stromschienenanordnung gleiche Stromschienen verwendet werden können. Dies erleichtert durch die Gleichteile die Logistik und Lagerhaltung für die Fertigung einer solchen Stromschienenanordnung.

Bei einer weiteren vorteilhaften Ausgestaltung der Erfindung ist im Überlappungsbereich der Stromschienenanordnung zwischen den Stromschienen eine Isolierschicht angeordnet und die Stromschienen liegen jeweils zumindest abschnittsweise an der Isolierschicht an. Es hat sich als vorteilhaft erwiesen, zwischen den Stromschienen eine Isolierschicht anzuordnen. In vorteilhafter Weise hat diese eine gute elektrisch isolierende Eigenschaft. Dadurch wird erreicht, dass die Stromschienen trotz einer hohen Potentialdifferenz räumlich nah zueinander angeordnet werden können ohne dass Schäden durch Überschläge auftreten können. Die räumliche Nähe der Stromschienen bewirkt im Überlappungsbereich der Stromschienenanordnung, dass sich die Magnetfelder, die durch die in den Stromschienen fließenden Strömen entstehen, weitestgehend kompensieren. Darüber hinaus wird durch die Isolierschicht sichergestellt, dass ein Mindestabstand zwischen den Stromschienen durch die Materialdicke der Isolierschicht eingehalten wird. Darüber hinaus gibt der Aufbau, bei dem die Isolierschicht zwischen den Stromschienen angeordnet ist diesem Aufbau eine höhere mechanische Stabilität. Die Isolierschicht wird auch als Isolator bezeichnet.

Bei einer weiteren vorteilhaften Ausgestaltung der Erfindung weisen die Stromschienen jeweils mindestens zwei Stege mit jeweils mindestens einem Anschlusselement auf. Diese Ausgestaltung eignet sich dazu, mehrere Halbleitermodule mit der Stromschienenanordnung zu verbinden. Alternativ oder ergänzend kann auch ein Halbleitermodul derart modular aufgebaut sein, dass es mehrere gleichartige Gleichspannungsanschlüsse, also mehr als einen DC+ und mehr als einen DC- Anschluss aufweist. Somit kann die Leistungsfähigkeit eines Halbleitermoduls dadurch gesteigert werden, dass im Aufbau des Halbleitermoduls mehrere Untermodule mit eigenen Anschlüssen vorhanden sind, wobei die Anschlüsse der Untermodule auch die Anschlüsse des Halbleitermoduls darstellen.

Die Stromschienen mit mehreren Stegen eignen sich auch insbesondere für den Aufbau einer Brückenschaltung bei der mehrere Phasen auf der Wechselspannungsseite über Halbleitermodule mit dem gleichen Zwischenkreis, insbesondere gleichem Zwischenkreiskondensator oder gleichen Zwischenkreiskondensatoren, auf der Gleichspannungsseite verbunden sind.

In beiden Fällen hat es sich als vorteilhaft erwiesen, dass Paare von Anschlusselementen, die zur Verbindung mit Gleichspannungsanschlüssen des gleichen Halbleitermodul vorgesehen sind, jeweils eine Achse bilden und diese Achsen der unterschiedlichen Halbleitermodule parallel zueinander verlaufen. Als besonders vorteilhaft hat es sich erwiesen, wenn alle Anschlusselemente der Stromschienenanordnung auf einer gemeinsamen Achse liegen. Damit kann sowohl die Stromschienenanordnung wie auch die Halbleitermodule auf einfache und platzsparende Weise angeordnet werden. Darüber hinaus ist bei dieser Anordnung die Kopplung der einzelnen Anschlüsse der Halbleitermodule, insbesondere die Kopplung zwischen Anschlüssen unterschiedlicher Halbleitermodule sehr gering bzw. nicht mehr nachweisbar.

Bei einer weiteren vorteilhaften Ausgestaltung der Erfindung weist das Stromrichtermodul mindestens zwei Halbleitermodule auf, wobei die Halbleitermodule bezüglich ihrer Gleichspannungsanschlüsse in einer Parallelschaltung angeordnet sind. Die störende Wirkung der Einkopplung von Magnetfeldern ist insbesondere dann groß, wenn es sich um unterschiedliche Phasen eines Stromrichtermoduls handelt. Unterschiedliche Phasen eines Stromrichtermoduls werden durch separate Halbleitermodule aufgebaut. Um diese verschiedenen Halbleitermodule eines Stromrichtermoduls weitgehend voneinander zu entkoppeln, hat sich die Verwendung einer Stromschienenanordnung als günstig erwiesen, die jeweils Stromschienen mit mehreren Stegen und damit auch Stromschienen mit mehreren Anschlusselementen aufweist. Mit diesen kann eine Entkopplung der Halbleitermodule dann besonders günstig erfolgen, wenn die Halbleitermodule im Stromrichtermodul derart angeordnet sind, dass die Anschlüsse, insbesondere die Gleichspannungsanschlüsse, der einzelnen Halbleitermodule jeweils eine Achse bilden und diese Achsen zumindest parallel zueinander verlaufen. Als besonders günstig hat es sich erwiesen, wenn die Gleichspannungsanschlüsse der einzelnen Halbleitermodule in einer Flucht stehen, d.h. dass diese auf einer Achse liegen.

Bei einer weiteren vorteilhaften Ausgestaltung der Erfindung weist das Halbleitermodul mindestens zwei Reihenschaltungen von Halbleiterschaltern auf und weist mindestens vier Gleichspannungsanschlüsse auf. Das Halbleitermodul kann derart modular aufgebaut sein, dass es nicht nur eine sondern mehrere, d.h. mehr als eine, Halbbrücken aufweist. Bei einer Halbbrücke sind mindestens zwei Halbleiterschalter in einer Reihenschaltung angeordnet. Zur Erhöhung der Leistungsfähigkeit hat es sich als vorteilhaft erwiesen, mehrere Halbbrücken in einem Modul anzuordnen. Damit kann die Leistungsfähigkeit einer Phase erhöht werden oder mehrere Phasen in ein Halbleitermodul integriert werden. Bei mehr als zwei Brückenschaltungen können auch beide Vorteile gleichzeitig erzielt werden.

Dabei hat es sich als besonders vorteilhaft erwiesen, wenn die Gleichspannungsanschlüsse unterschiedlicher Halbbrücken des modularen Halbleitermoduls modulintern voneinander isoliert sind und durch die Stromschienenanordnung elektrisch miteinander verbunden werden. Dabei weist jede Brückenschaltung mindestens zwei Gleichspannungsanschlüsse. Das sind mindestens ein DC+ Anschluss und mindestens ein DC- Anschluss. Somit weist das modulare Halbleitermodul mindestens vier Gleichspannungsanschlüsse auf.

Der Vorteil dieses modularen Halbleitermoduls liegt darin, die Leistungsfähigkeit eines Halbleitermoduls einfach durch das Hinzufügen paralleler Halbbrücken steigern zu können. Darüber hinaus bietet das modulare Halbleitermodul die Möglichkeit, mehrere Phasen eines Stromrichters mit einem Halbleitermodul realisieren zu können. Durch die Stromschienenanordnung gelingt es, die Kopplung, insbesondere die magnetische Kopplung zwischen den Gleichspannungsanschlüssen derart zu minimieren, dass die einzelnen Halbbrücken unabhängig voneinander oder zumindest nahezu unabhängig voneinander betrieben werden können, selbst dann, wenn die Halbbrücken im Halbleitermodul in geringem Abstand oder in unmittelbarer Nähe zueinander angeordnet sind.

Im Folgenden wird die Erfindung anhand der in den Figuren dargestellten Ausführungsbeispiele näher beschrieben und erläutert. Es zeigen:
- FIG 1: Komponenten eines Stromrichtermoduls,
- FIG 2: Teile einer Stromschienenanordnung,
- FIG 3: ein Ausführungsbeispiel einer Stromschienenanordnung mit einer Isolierschicht,
- FIG 4: eine Isolierschicht
- FIG 5 - FIG 8: weitere Ausführungsbeispiele einer Stromschienenanordnung,
- FIG 9: die Lage einer zweiten Achse,
- FIG 10: die Lage einer ersten oder einer weiteren ersten Achse,
- FIG 11 - FIG 13: weitere Ausführungsbeispiele einer Stromschienenanordnung und
- FIG 14: ein modular aufgebautes Halbleitermodul.

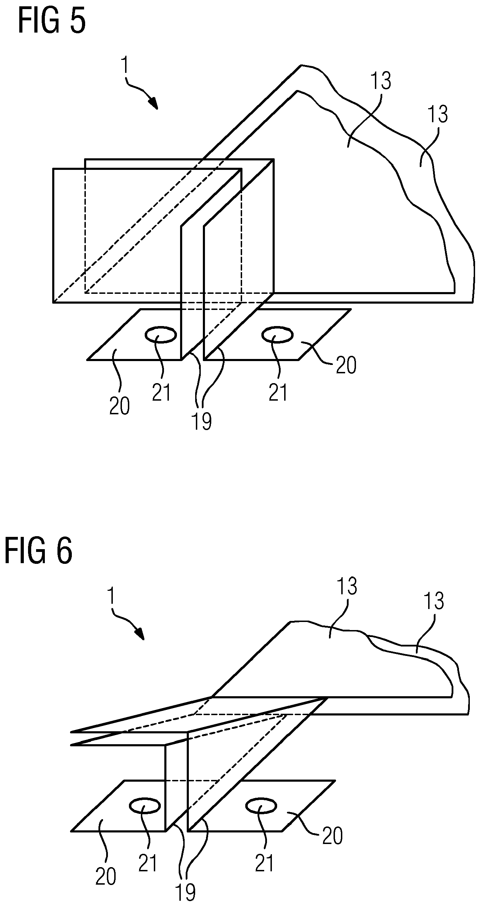

Die in den Figuren 5, 6 und 11 dargestellten Ausführungsbeispiele fallen nicht unter den Gegenstand des Anspruchs 1 sondern dienen lediglich dem Verständnis der Erfindung.

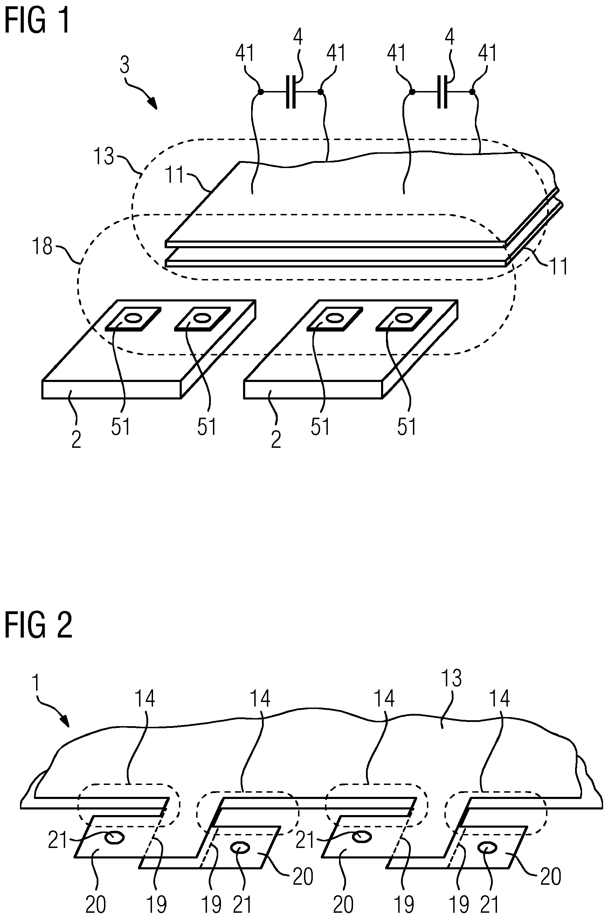

FIG 1 zeigt Teile eines Stromrichtermoduls 3. Aus Gründen der Übersichtlichkeit sind hier Komponenten weggelassen bzw. nur vereinfacht dargestellt. Aufgabe einer Stromschienenanordnung 1 ist es, ein Halbleitermodul 2 oder mehrere Halbleitermodule 2 mit einem oder mehreren Kondensatoren 4 elektrisch zu verbinden. Von der Stromschienenanordnung 1 ist in dieser Darstellung nur der Überlappungsbereich 13 dargestellt. Auf die Darstellung des Anschlussbereichs 18, dessen Lage in der vorliegenden Figur gekennzeichnet ist, wurde verzichtet. In diesem Ausführungsbeispiel weist die Stromschienenanordnung 1 zwei Stromschienen auf, wie es für Zweipunktumrichter zweckmäßig ist. Aber auch Anwendungsbeispiele mit drei oder noch mehr Stromschienen sind beispielsweise für Dreipunktumrichter oder allgemein Mehrpunktumrichter sinnvoll. Zu erkennen ist, dass im Überlappungsbereich 13 die Stromschienen 11 überlappend, das heißt je nach Blickrichtung nebeneinander oder übereinander liegend, angeordnet sind. Die beiden Stromschienen 11 sind jeweils mit einer Elektrode 41 eines Kondensators 4 elektrisch verbunden. Für den Anschluss der Halbleitermodule 2 an die Stromschienen 11 stehen an den Halbleitermodulen 2 Gleichspannungsanschlüsse 51 zur Verfügung. Auf die Darstellung der wechselspannungsseitigen Anschlüsse der Halbleitermodule 2 sowie auf eine genaue Darstellung der Realisierung eines Kondensators 4 wurde aus Gründen der Übersichtlichkeit verzichtet.

FIG 2 zeigt eine Ausführungsform des in FIG 1 nicht dargestellten Anschlussbereichs 18. Dabei handelt es sich um Teile der Stromschienenanordnung 1 in der Umgebung des Anschlussbereichs 18. Auch hier weist die Stromschienenanordnung 1 zwei überlappende Stromschienen 11 auf. Die Stromschienen 11 weisen einen Überlappungsbereich 13 und Stege 20 auf. Der Übergang 19 zwischen Steg 20 und Überlappungsbereich 13 ist in dieser Figur durch eine gestrichelte Linie gekennzeichnet. Die Stege 20 sind im Gegensatz zum Überlappungsbereich 13 überlappungsfrei ausgeführt. Die Stege 20 weisen ein Anschlusselement 21 auf, mit dem der elektrische Kontakt zu einem hier nicht dargestellten Gleichspannungsanschluss 51 eines Halbleitermoduls 2 hergestellt werden kann. Die Anschlusselemente 21 können wie im dargestellten Ausführungsbeispiel auf einfache Weise durch ein Loch realisiert werden. Zur Verbindung mit einem Halbleitermodul 2 wird eine Schraube durch das Loch als Anschlusselement 21 gesteckt und mit einem Gleichspannungsanschluss 51 des Halbleitermoduls 2 verschraubt. Dabei sind die Stege 20 so ausgerichtet, dass in ihnen nur ein Strom fließen kann, der eine Richtung hat, die im Wesentlichen der Richtung einer Verbindung zweier Anschlusselemente 21 entspricht. Ein Strom senkrecht zu der Richtung, die sich durch die Verbindung zweier Anschlusselemente 21 ergibt, wird durch den Isolierbereich 14 verhindert. Bei dem Isolierbereich 14 handelt es sich im einfachen Fall um einen Bereich, indem kein leitendes Material der Stromschiene 11 vorhanden ist. Der Isolierbereich 14 wird in diesem Ausführungsbeispiel durch eine räumliche Trennung gebildet. Diese Ausnehmung bewirkt, dass ein Stromfluss senkrecht zur Richtung der zweiten Achse (gebildet durch Anschlusselemente 21 der Stege) im Steg reduziert oder verhindert wird. Durch den Stromfluss, der im Wesentlichen in Richtung einer Achse erfolgt, die sich durch die Verbindung der Anschlusselemente ergibt, werden keine Magnetfelder erzeugt, die auf das jeweilig andere Anschlusselement 21 einwirken. Somit wird eine Kopplung der Anschlüsse zuverlässig verhindert oder zumindest deutlich reduziert. Erst von dem Anschlusselement 21 betrachtet jenseits des Übergangs 19 zwischen Steg 20 und Überlappungsbereich 13 verläuft der Strom in der Stromschiene 11 senkrecht zu der Achse, die sich durch die Verbindung der Anschlusselemente ergibt. Da allerdings in diesem Bereich die beiden Stromschienen 11 sich gegenseitig überlappen, kompensieren sich die Magnetfelder dieser beiden Ströme. Diese beiden Ströme werden auch als Hinstrom und Rückstrom bezeichnet, da sie betraglich gleich sind und sich nur durch das Vorzeichen unterscheiden.

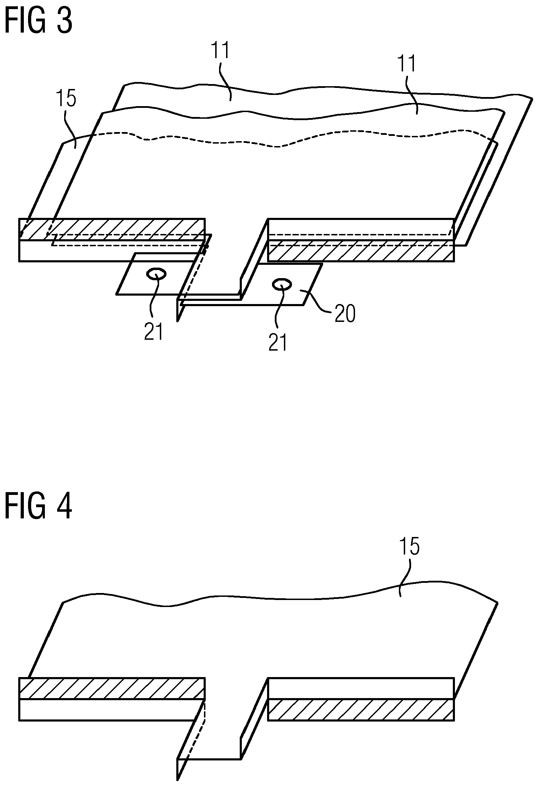

FIG 3 zeigt eine Isolierschicht 15 die zwischen den Stromschienen 11 angeordnet ist. Diese Isolierschicht 15 erlaubt durch Ihre isolierende Wirkung, die Stromschienen 11 auch bei einer hohen Potenzialdifferenz eng aneinander anordnen zu können, ohne dabei Entladungsvorgänge, wie beispielsweise Überschläge, zu verursachen. Darüber hinaus gewährleistet die Isolierschicht 15 einen gleichbleibenden Abstand zwischen den Stromschienen 11. Ferner verleiht die Isolierschicht 15 dem Aufbau der Stromschienenanordnung eine hohe Festigkeit, insbesondere dann wenn die Stromschienen an der Isolierschicht 15 befestigt sind.

FIG 4 zeigt die Isolierschicht 15 ohne anliegende Stromschienen 11. Dabei kann auf die schraffierten Flächen der Isolierschicht 15 verzichtet werden, ohne die isolierende Eigenschaft negativ zu beeinflussen. Die Isolation zwischen den verschiedenen Potentialen kann als Kunststoffformteil (Spritzgussteil oder Formpressteil) ausgestaltet werden sein, so dass die Isolierbereiche in Form von Ausschnitten in den Stromschienen minimal ausgeformt sein können. So ergibt sich eine niederohmige und niederinduktive Stromschienenanordnung 1.

FIG 5 zeigt ein weiteres Ausführungsbeispiel einer Stromschienenanordnung 1. Zur Vermeidung von Wiederholungen wird auf die Beschreibung zur FIG 2 und auf die dort eingeführten Bezugszeichen verwiesen. Ähnlich wie in FIG 2 fließt in den Stegen 20 nur ein Strom in Richtung einer Achse, die durch die Verbindung der Anschlusselemente 21 gebildet wird. Gerade diese Richtung des Stroms verhindert die Ausbildung eines Magnetfeldes, das sich auf den jeweils anderen Anschluss erstreckt. Dadurch kann eine Entkopplung der Anschlüsse auf einfache Weise realisiert werden. Erst von dem Anschlusselement 21 betrachtet jenseits des Übergangs 19 zwischen Steg 20 und Überlappungsbereich 13 verläuft der Strom in der Stromschiene 11 senkrecht zu der Achse, die sich durch die Verbindung der Anschlusselemente ergibt. Da allerdings in diesem Bereich die beiden Stromschienen 11 sich gegenseitig überlappen, kompensieren sich die Magnetfelder dieser beiden Ströme.

Auch wenn in diesem Ausführungsbeispiel für jede Stromschiene 11, die einen Überlappungsbereich 13 und den Steg 20 umfasst, nur jeweils ein Steg 20 dargestellt ist, kann die Stromschienenanordnung 1 darüber hinaus weitere Stege 20 mit Anschlusselementen 21 umfassen, um mehrere Halbleitermodule 2 kontaktieren zu können und/oder mehrere Gleichspannungsanschlüsse 51 eines Halbleitermoduls 2 kontaktieren zu können. Der Vorteil dieses Ausführungsbeispiels besteht unter anderem darin, dass die Anschlusselemente 21 auf gleicher Höhe liegen. Da üblicherweise auch die Gleichspannungsanschlüsse 51 eines Halbleitermoduls 2 sich auf gleicher Höhe befinden, kann die Verbindung beispielsweise mittels einer Schraube für beide Anschlusselemente 21 gleich ausgeführt werden.

FIG 6 zeigt ein weiteres Ausführungsbeispiel einer Stromschienenanordnung 1. Zur Vermeidung von Wiederholungen wird auf die Beschreibung zu den Figuren 2 und 5 sowie auf die dort eingeführten Bezugszeichen verwiesen. Auch dieses weist den Vorteil auf, dass die Anschlusselemente 21 auf gleicher Höhe liegen. Gegenüber des in FIG 5 dargestellten Ausführungsbeispiel des sich diese Anordnung besonders einfach realisieren, da die Stromschiene aus einem flächigen Leiter ausgestanzt und in die entsprechende dargestellte Form gebracht werden kann.

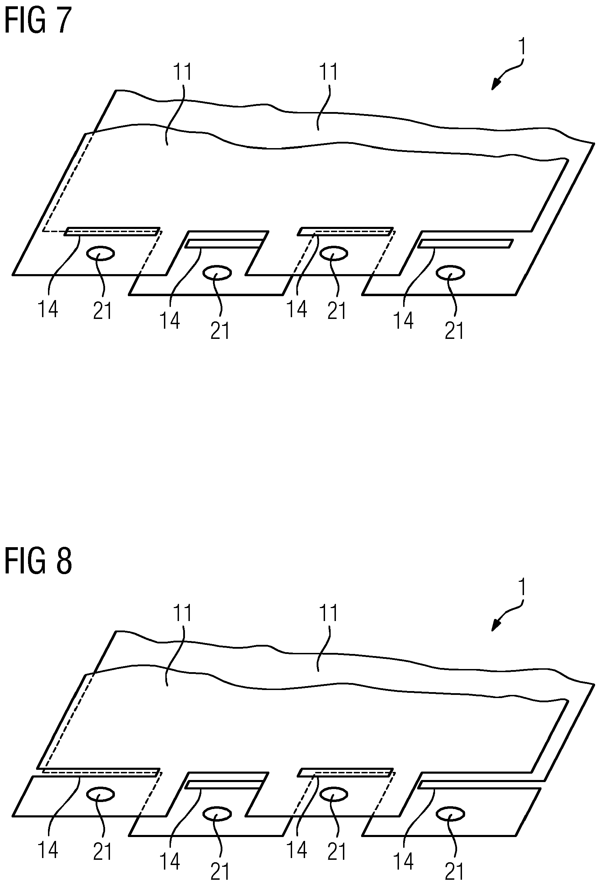

Die Figuren 7 und 8 zeigen Ausführungsbeispiele in denen die Stege 20 an zwei Übergängen mit dem Überlappungsbereich 13 verbunden sind. Dies verleiht dem Aufbau eine hohe Stabilität. Zur Vermeidung von Wiederholungen wird auf die Beschreibung zu den Figuren 2, 5 und 6 sowie auf die dort eingeführten Bezugszeichen verwiesen. Durch die hohe Stabilität an den Anschlusselementen 21 kann die Stromschienenanordnung 1 mittels der Anschlusselemente 21 mechanisch befestigt werden. Auf eine zusätzliche Befestigung der Stromschienenanordnung 1 kann verzichtet werden oder zumindest entsprechend klein dimensioniert werden. Bei dem Ausführungsbeispiel der FIG 7 weisen alle Stege jeweils zwei Übergänge zum Überlappungsbereich auf. Damit sind die ohmschen Verhältnisse für die einzelnen Anschlusselemente 21 gleich oder zumindest nahezu gleich. Im Gegensatz dazu haben die Stege 20 des Ausführungsbeispiels der FIG 8 jeweils nur einen Übergang zwischen Steg 20 und Überlappungsbereich 13. Damit sind die ohmschen Verhältnisse unterschiedlich, jedoch das induktive Verhalten ist in den einzelnen Anschlusselementen 21 der unterschiedlichen Stege 20 gleich oder zumindest nahezu gleich.

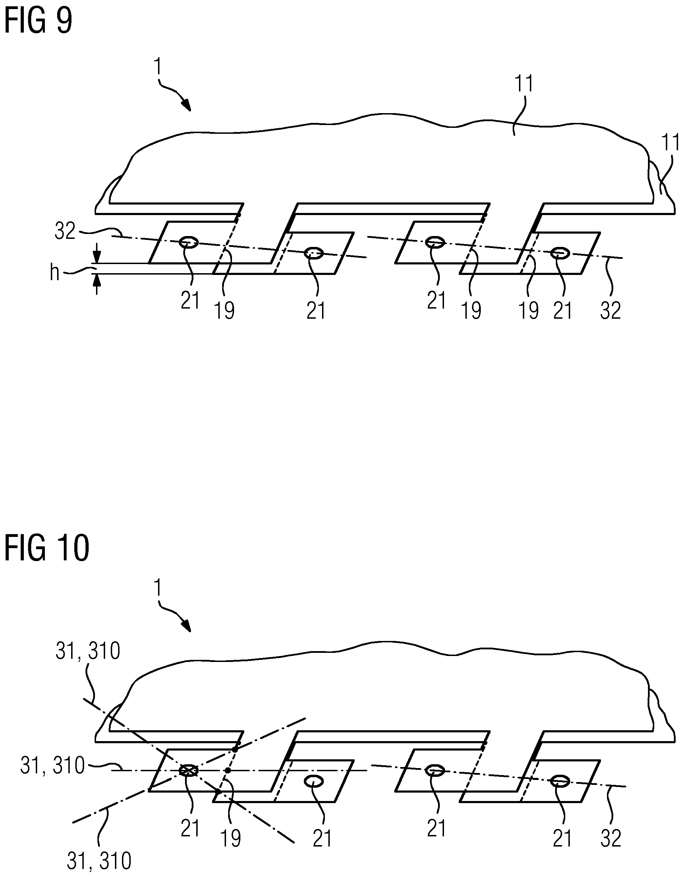

FIG 9 und FIG 10 sollen veranschaulichen, wie die beschriebenen ersten und zweiten Achsen gebildet werden. In FIG 9 ist dazu zweimal eine zweite Achse 32 eingezeichnet, die durch die Anschlusselemente 21 verläuft. Bei einer Beurteilung zum parallelen Verlauf wird bei der Beschreibung mit den Worten "im wesentlichen" angenommen, dass der Höhenunterschied h zwischen den beiden Anschlusselementen 21 vernachlässigbar ist. Untersuchungen haben gezeigt, dass der durch den Höhenunterschied h hervorgerufene vernachlässigbare Winkel je nach Ausgestaltung der Stege 20 im Bereich 0° bis 10° oder 0° bis 20° liegt. Somit kann der Verlauf einer ersten Achse 31,310 und einer zweiten Achse 32 auch noch dann als im Wesentlichen parallel angesehen werden, wenn eine Variation der zweiten Achse 32 in den oben genannten Bereichen dazu führt, dass die beiden Achsen nach Durchführung der Variation parallel angeordnet sind.

FIG 10 zeigt wie eine erste Achse 31, bzw. eine weitere erste Achse 310 gebildet werden kann. Dazu wird das Anschlusselement 21 und ein Punkt des Übergangs 19 zwischen Steg 20 und Überlappungsbereich 13 miteinander verbunden. Dabei wird deutlich dass abhängig von der Wahl des Punktes am Übergang 19 sich die ersten Achsen 31, bzw. die weiteren ersten Achsen 310 unterscheiden können. Zum Vergleich ist auf der rechten Seite noch einmal eine zweite Achse 32 eingezeichnet, die durch die Anschlusspunkte 21 der Stege 20 auf der rechten Seite verläuft.

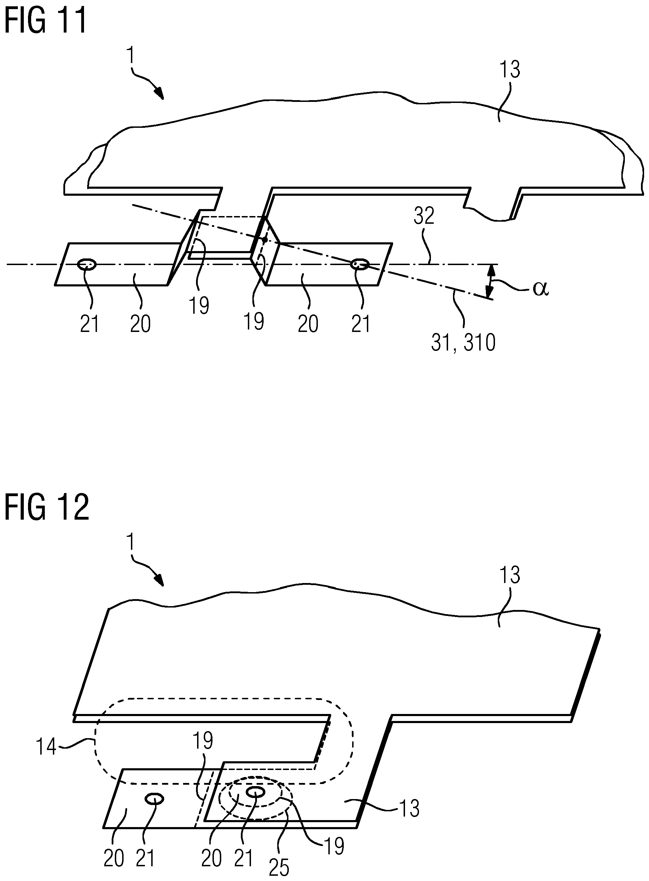

FIG 11 zeigt ein weiteres Ausführungsbeispiel eines Stromschienenanordnung 1. Zur Vermeidung von Wiederholungen wird auf die Beschreibung zu den vorhergehenden Figuren sowie auf die dort eingeführten Bezugszeichen verwiesen. In diesem Ausführungsbeispiel liegen die Anschlusselemente nicht in einer Ebene mit dem Überlappungsbereich 13. Der Steg 20 weist einen Abschnitt auf, der den Abschnitt um das Anschlusselement 21 außerhalb der Ebene des Überlappungsbereichs 13 bringt. Wird nun für dieses Ausführungsbeil eine erste Achse 31 bzw. eine weitere erste Achse 310 gebildet, die durch das Anschlusselement 21 und einem Punkt des Übergangs 19 zwischen Steg 20 und Überlappungsbereich 13 gebildet wird, so schneidet diese erste, bzw. weitere erste Achse 31, 310 die zweite Achse 32 in einem Winkel α. Zwei unterschiedliche Anschlusselemente 21 können insbesondere dann besonders gut entkoppelt werden wenn der Winkel α in einem Bereich von 0° und 45° liegt. Als besonders vorteilhaft hat es sich erwiesen, wenn der Winkel α einen Wert von 0° aufweist. In diesem Fall liegen erste, bzw. weitere erste Achse 31, 310 parallel zur zweiten Achse.

Mit diesem Ausführungsbeispiel ist es auf einfache Weise möglich, einen Unterschied im Abstand der ersten und zweiten Stromschiene 11, wie er im Überlappungsbereich auftritt, an den Anschlusselementen auszugleichen. Damit liegen die Stromschienen 11 parallel zur zweiten Achse 32.

Das zweite Paar an Stegen 20 wurde in der FIG 11 nicht dargestellt (Schnittkante), um die Übersichtlichkeit der Zeichnung zu erhöhen. Auch in diesem Ausführungsbeispiel kann die Stromschienenanordnung 1 durch Hinzufügen weiterer Stege 20 mit weiteren Anschlusselementen 21 für die Kontaktierung mit weiteren Gleichspannungsanschlüssen 51 eines oder mehrerer Halbleitermodulen 2 auf einfache Weise erweitert werden.

FIG 12 zeigt ein weiteres Ausführungsbeispiel eines Stromschienenanordnung 1. Zur Vermeidung von Wiederholungen wird auf die Beschreibung zu den vorhergehenden Figuren sowie auf die dort eingeführten Bezugszeichen verwiesen. Auch dieses Ausführungsbeispiel weist 2 Anschlusselemente 21 auf. Auf der linken Seite in der unteren Stromschiene 11 und auf der rechten Seite in der oberen Stromschiene 11. Damit das rechte Anschlusselement 21 mit einem nicht dargestellten Halbleitermodul kontaktiert werden kann, befindet sich in der unteren Stromschiene ein Montageloch 25, durch das beispielsweise eine Schraube von der oberen Stromschiene durch das Montageloch 25 mit einem Halbleitermodul 2 verbunden werden kann ohne einen elektrischen Kontakt mit der unteren herzustellen. Im Bereich des Montagelochs 25 stellt die obere Stromschiene 11 einen Steg 20 dar. Der Isolierbereich 14, hier als Ausnehmung realisiert, verhindert bzw. vermindert einen Stromfluss in den Stegen 20 senkrecht zu einer Verbindungslinie, die durch die Anschlusselemente 21 gebildet wird. Auch in diesem Ausführungsbeispiel kann die Stromschienenanordnung 1 durch Hinzufügen weiterer Stege 20 mit weiteren Anschlusselementen 21 für die Kontaktierung mit weiteren Gleichspannungsanschlüssen 51 eines oder mehrerer Halbleitermodulen 2 auf einfache Weise erweitert werden.

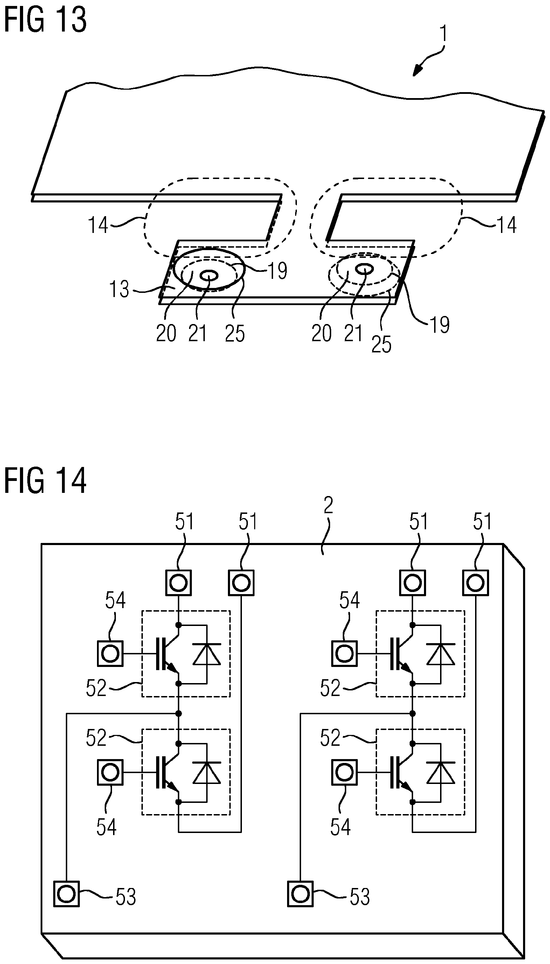

FIG 13 zeigt ein weiteres Ausführungsbeispiel eines Stromschienenanordnung 1. Zur Vermeidung von Wiederholungen wird auf die Beschreibung zu den vorhergehenden Figuren sowie auf die dort eingeführten Bezugszeichen verwiesen. Im Gengensatz zum Ausführungsbeispiel der FIG 12 weist dieses Ausführungsbeispiel zwei Montagelöcher 25 auf, die dazu dienen, bei der Kontaktierung mit einem Halbleitermodul keinen elektrischen Kontakt zwischen den Stromschienen 11 herzustellen. Der Steg wird damit bei beiden Anschlusselementen durch eine kreisförmige Fläche gebildet, der sich dort befindet, wo die jeweils andere Stromschiene das Montageloch aufweist. Das Anschlusselement 21 befindet sich beim linken Steg 20 in der oberen Stromschiene und beim linken Steg 20 in der unteren Stromschiene. Der Isolierbereich 14, hier als Ausnehmung realisiert, verhindert bzw. vermindert einen Stromfluss in den Stegen 20 senkrecht zu einer Verbindungslinie, die durch die Anschlusselemente 21 gebildet wird. Auch in diesem Ausführungsbeispiel kann die Stromschienenanordnung 1 durch Hinzufügen weiterer Stege 20 mit weiteren Anschlusselementen 21 für die Kontaktierung mit weiteren Gleichspannungsanschlüssen 51 eines oder mehrerer Halbleitermodulen 2 auf einfache Weise erweitert werden.

FIG 14 zeigt schematisch den Aufbau eines modularen Halbleitermoduls 2. In diesem Ausführungsbeispiel sind zwei Brückenmodule angeordnet. Jedes dieser Brückenmodule weist eine Reihenschaltung zweier Halbleiterschalter 52 auf. Der Verbindungspunkt der beiden Halbleiterschalter 52 ist mit dem Phasenanschluss 53 verbunden, der an der Außenseite des Halbleitermoduls 2 angeordnet ist. Die Phasenanschlüsse 52 können miteinander verbunden werden, um die Leistungsfähigkeit einer Phase zu erhöhen oder unterschiedliche Phasen eines Stromrichters bilden. Dazu sind noch die Enden der Reihenschaltung als Gleichspannungsanschlüsse 51 an die Außenseite des Halbleitermoduls geführt. Somit hat jede Brückenschaltung mindestens zwei Gleichspannungsanschlüsse 51. Dies sind mindestens ein DC+ Anschluss und mindestens ein DC- Anschluss. Um den Widerstand beim Kontakt des Halbleitermoduls zu erniedrigen können mehr als zwei Gleichspannungsanschlüsse für eine Halbbrücke vorgesehen werden. Werden die Gleichspannungsanschlüsse 51 mit einer hier vorgeschlagenen Stromschienenanordnung 1 kontaktiert, so kann sichergestellt werden, dass die Gleichspannungsanschlüsse 51 voneinander entkoppelt sind oder zumindest nur eine derart geringe Kopplung aufweisen, dass die einzelnen Halbbrücken trotz räumlicher Nähe bei der Anordnung in einem modularen Halbleitermodul 2 unabhängig voneinander betrieben werden können.

Die Steueranschlüsse 54 dienen zum Ansteuern der Halbleiterschalter 52.

Die Halbbrücken können auch mehr als zwei in Reihe angeordnete Halbleiterschalter 52 aufweisen, um beispielsweise die Phase eines Mehrpunktwechselrichter, insbesondere eines 3-Punkt-Wechselrichters, auf einfache Weise herstellen zu können.

Obwohl die Erfindung im Detail durch die bevorzugten Ausführungsbeispiele näher illustriert und beschrieben wurde, ist die Erfindung nicht allein auf das offenbarte Beispiel beschränkt und andere Variationen können vom Fachmann hieraus abgeleitet werden, ohne den Schutzumfang der Erfindung zu verlassen.

Zusammenfassend betrifft die Erfindung eine Stromschienenanordnung zur elektrischen Kontaktierung mindestens eines Halbleitermoduls, wobei die Stromschienenanordnung mindestens zwei Stromschienen aufweist, wobei zumindest in einem Überlappungsbereich der Stromschienenanordnung die Stromschienen sich gegenseitig überlappend angeordnet sind, wobei die Stromschienen elektrisch voneinander isoliert sind, wobei die Stromschienen jeweils mindestens einen Steg mit einem Anschlusselement aufweisen, wobei die Stege der Stromschienen überlappungsfrei angeordnet sind. Zur Reduzierung der Wechselwirkung zwischen den Anschlüssen des Halbleitermoduls oder der Halbleitermodule wird vorgeschlagen, die Stege derart auszurichten, dass eine erste Achse gebildet werden kann, die durch das Anschlusselement des jeweiligen Stegs und einem Punkt eines Übergangs des jeweiligen Stegs zu dem Überlappungsbereich der Stromschienenanordnung verläuft, und die eine zweite Achse, die durch eine Verbindung zweier Anschlusselemente der Stege gebildet wird, in einem Winkel zwischen 0° und 45° schneidet, wobei die Stromschienen jeweils einen Isolierbereich aufweisen, der derart angeordnet ist, einen Strom im Steg in einer Richtung senkrecht zur zweiten Achse zu reduzieren oder zu verhindern. Die Erfindung betrifft weiter ein Stromrichtermodul mit einer solchen Stromschienenanordnung.

## Patentansprüche

1. Stromschienenanordnung (1) zur elektrischen Kontaktierung mindestens eines Halbleitermoduls (2), wobei die Stromschienenanordnung (1) mindestens zwei Stromschienen (11) aufweist, wobei zumindest in einem Überlappungsbereich (13) der Stromschienenanordnung (1) die Stromschienen (11) sich gegenseitig überlappend angeordnet sind, wobei die Stromschienen (11) elektrisch voneinander isoliert sind, wobei die Stromschienen (11) jeweils mindestens einen Steg (20) mit einem Anschlusselement (21) aufweisen, wobei die Stege (20) der Stromschienen (11) überlappungsfrei angeordnet sind, wobei die Stege (20) derart ausgerichtet sind, dass eine erste Achse (31) gebildet werden kann,
- die durch das Anschlusselement (21) des jeweiligen Stegs (20) und einem Punkt eines Übergangs (19) des jeweiligen Stegs (20) zu dem Überlappungsbereich (13) der Stromschienenanordnung (1) verläuft, und
- die eine zweite Achse (32), die durch eine Verbindung zweier Anschlusselemente (21) der Stege (20) gebildet wird, in einem Winkel zwischen 0° und 45° schneidet,
wobei die Stromschienenanordnung (1) einen Isolierbereich (14) aufweist, der derart angeordnet ist, einen Strom im Steg (20) in einer Richtung senkrecht zur zweiten Achse (32) zu reduzieren oder zu verhindern, **dadurch gekenn- zeichnet,** dass sich der Überlappungsbereich (13) und die Stege (20) jeweils in einer Ebene befinden.

2. Stromschienenanordnung (1) nach Anspruch 1, wobei der Isolierbereich (14) derart angeordnet ist, die Ausbildung eines Stromes im Übergang (19) zwischen Steg (20) und Überlappungsbereich (13) in Richtung senkrecht zur zweiten Achse (32) zu reduzieren oder zu verhindern.

3. Stromschienenanordnung (1) nach einem der Ansprüche 1 oder 2, wobei der Isolierbereich derart angeordnet ist, dass er sich an einem Überlappungsbereich (13) anschließt.

4. Stromschienenanordnung (1) nach einem der Ansprüche 1 bis 3, wobei der Isolierbereich abschnittsweise an einer Grenze zwischen Steg (20) und Überlappungsbereich (13) angeordnet ist.

5. Stromschienenanordnung (1) nach einem der Ansprüche 1 bis 4, wobei zumindest zwei der Stege (20) symmetrisch zueinander ausgebildet sind.

6. Stromschienenanordnung (1) nach einem der Ansprüche 1 bis 5, wobei im Überlappungsbereich (13) der Stromschienenanordnung (1) zwischen den Stromschienen (11) eine Isolierschicht (15) angeordnet ist und die Stromschienen (11) jeweils an der Isolierschicht (15) zumindest abschnittsweise anliegen.

7. Stromschienenanordnung (1) nach einem der Ansprüche 1 bis 6, wobei die Stromschienen (11) jeweils mindestens zwei Stege (20) mit jeweils mindestens einem Anschlusselement (21) aufweisen.

8. Stromrichtermodul (3) aufweisend
- eine Stromschienenanordnung (1) nach einem der Ansprüche 1 bis 7,
- mindestens ein Halbleitermodul (2) und
- mindestens einen Kondensator (4),
wobei das Halbleitermodul (2) zwei Gleichspannungsanschlüsse (51) aufweist, wobei die Gleichspannungsanschlüsse (51) jeweils mit einem Anschlusselement (21) der Stromschienenanordnung (1) elektrisch verbunden sind, wobei der Kondensator (4) zwei Elektroden (41) aufweist, wobei die Stromschienen (11) der Stromschienenanordnung (1) jeweils mit einer Elektrode (41) des Kondensators (4) elektrisch verbunden sind.

9. Stromrichtermodul (3) nach Anspruch 8, wobei das Stromrichtermodul (3) mindestens zwei Halbleitermodule (2) aufweist, wobei die Halbleitermodule (2) bezüglich ihrer Gleichspannungsanschlüsse (51) in einer Parallelschaltung angeordnet sind.

10. Stromrichtermodul (3) nach einem der Ansprüche 8 oder 9, wobei das Halbleitermodul (2) mindestens zwei Reihenschaltungen von Halbleiterschaltern (52) aufweist und mindestens vier Gleichspannungsanschlüsse (51) aufweist.

11. Verwendung einer Stromschienenanordnung (1) nach einem der Ansprüche 1 bis 7, zur Verbindung mindestens eines Halbleitermoduls (2) mit mindestens einem Kondensator (4), insbesondere in einem Stromrichter.

## Claims

1. Busbar arrangement (1) for making electrical contact with at least one semiconductor module (2), wherein the busbar arrangement (1) has at least two busbars (11), wherein the busbars (11) are arranged in a mutually overlapping manner at least in an overlap region (13) of the busbar arrangement (1), wherein the busbars (11) are electrically insulated from one another, wherein the busbars (11) each have at least one web (20) with a connection element (21), wherein the webs (20) of the busbars (11) are arranged without an overlap, wherein the webs (20) are oriented such that a first axis (31) can be formed,
- which runs through the connection element (21) of the respective web (20) and a point of a transition (19) of the respective web (20) to the overlap region (13) of the busbar arrangement (1), and
- which intersects with a second axis (32), which is formed by a connection between two connection elements (21) of the web (20) at an angle of between 0° and 45°,
wherein the busbar arrangement (1) has an insulating region (14), which is arranged so as to reduce or to prevent a current in the web in a direction perpendicular to the second axis (32), **characterised in that** the overlap region (13) and the webs (20) are each located in one plane.

2. Busbar arrangement (1) according to claim 1, wherein the insulating region (14) is arranged so as to reduce or to prevent the formation of a current in a direction perpendicular to the second axis (32) in the transition (19) between web (20) and overlap region (13).

3. Busbar arrangement (1) according to one of claims 1 or 2, wherein the insulating region (14) is arranged such that it adjoins an overlap region (13).

4. Busbar arrangement (1) according to one of claims 1 to 3, wherein the insulating region is arranged in some sections at a boundary between web (20) and overlap region (13).

5. Busbar arrangement (1) according to one of claims 1 to 4, wherein at least two of the webs (20) are embodied symmetrically to one another.

6. Busbar arrangement (1) according to one of claims 1 to 5, wherein an insulating layer (15) is arranged in the overlap region (13) of the busbar arrangement (1) between the busbars (11) and the busbars (11) each adjoin the insulating layer (15) at least in some sections.

7. Busbar arrangement (1) according to one of claims 1 to 6, wherein the busbars (11) each have at least two webs (20) each with at least one connection element (21).

8. Converter module (3) having
- a busbar arrangement (1) according to one of claims 1 to 7,
- at least one semiconductor module (2) and
- at least one capacitor (4),
wherein the semiconductor module (2) has two direct current connections (51), wherein the direct current connections (51) are each connected electrically to a connection element (21) of the busbar arrangement (1), wherein the capacitor (4) has two electrodes (41), wherein the busbars (11) of the busbar arrangement (1) are each connected electrically to an electrode (41) of the capacitor (4).

9. Converter module (3) according to claim 8, wherein the converter module (3) has at least two semiconductor modules (2), wherein the semiconductor modules (2) are arranged in a parallel circuit as regards their direct current connections (51) .

10. Converter module (3) according to one of claims 8 or 9, wherein the semiconductor module (2) has at least two series circuits of semiconductor switches (52) and has at least four direct current connections (51).

11. Use of a busbar arrangement (1) according to one of claims 1 to 7 for connection of at least one semiconductor module (2) to at least one capacitor (4), in particular in a converter.

## Revendications

1. Agencement (1) de rails conducteurs pour la mise en contact électrique d'au moins un module (2) à semi-conducteur, l'agencement (1) de rails conducteurs ayant au moins deux rails (11) conducteurs, dans lequel, au moins dans une partie (13) de chevauchement de l'agencement (1) de rails conducteurs, les rails (11) conducteurs sont disposés en se chevauchant mutuellement, les rails (11) conducteurs étant isolés électriquement les uns des autres, les rails (11) conducteurs ayant chacun au moins une réglette (20), ayant un élément (21) de connexion, les réglettes (20) des rails (11) conducteurs étant disposées sans chevauchement, les réglettes (20) étant dirigées de manière à pouvoir former un premier axe (31),
- qui passe par l'élément (21) de connexion de la réglette (20) respective et par un point d'une transition (19) de la réglette (20) respective à la partie (13) de chevauchement du dispositif (1) de rails conducteurs, et
- qui coupe, suivant un angle compris entre 0° et 45°, un deuxième axe (32), formé par une liaison de deux éléments (21) de connexion des réglettes (20),
le dispositif (1) de rails conducteurs ayant une partie (14) isolante, disposée de manière à réduire ou à empêcher un courant dans la réglette (20) dans une direction perpendiculaire au deuxième axe (32), **caractérisé en ce que** la partie (13) de chevauchement et les réglettes (20) se trouvent, respectivement, dans un plan.

2. Dispositif (1) de rails conducteurs suivant la revendication 1, dans lequel la partie (14) isolante est disposée de manière à réduire ou à empêcher un courant de se constituer dans la transition (19) entre réglette (20) et partie (13) de chevauchement, dans une direction perpendiculaire au deuxième axe (32).

3. Dispositif (1) de rails conducteurs suivant l'une des revendications 1 ou 2, dans lequel la partie isolante est disposée de manière à se raccorder à une partie (13) de chevauchement.

4. Dispositif (1) de rails conducteurs suivant l'une des revendications 1 à 3, dans lequel la partie isolante est disposée par endroit à une limite entre réglette (20) et partie (13) de chevauchement.

5. Dispositif (1) de rails conducteurs suivant l'une des revendications 1 à 4, dans lequel au moins deux des réglettes (20) sont disposées de manière symétrique l'une de l'autre.

6. Dispositif (1) de rails conducteurs suivant l'une des revendications 1 à 5, dans lequel il est disposé une couche (15) isolante entre les rails (11) conducteurs dans la partie (13) de chevauchement du dispositif (1) de rails conducteurs et les rails (11) conducteurs s'appliquent chacun, au moins par endroit, à la couche (15) isolante.

7. Dispositif (1) de rails conducteurs suivant l'une des revendications 1 à 6, dans lequel les rails (11) isolants ont chacun au moins deux réglettes (20), ayant chacune au moins un élément (21) de connexion.

8. Module (3) de convertisseur, comportant
- un dispositif (1) de rails conducteurs suivant l'une des revendications 1 à 7,
- au moins un module (2) à semi-conducteur et
- au moins un condensateur (4),
le module (2) à semi-conducteur ayant deux bornes (51) de tension continue, les bornes (51) de tension continue étant connectées électriquement chacune à un élément (21) de connexion du dispositif (1) de rails conducteurs, le condensateur (6) ayant deux électrodes (41), les rails (11) conducteurs du dispositif (1) de rails conducteurs étant connectés électriquement, respectivement, à une électrode (41) du condensateur (4).

9. Module (3) de convertisseur suivant la revendication 8, dans lequel le module (3) de convertisseur a au moins deux modules (2) à semi-conducteur, les modules (2) à semi-conducteur étant montés suivant un circuit en parallèle, en ce qui concerne leurs bornes (51) de tension continue.

10. Module (3) de convertisseur suivant l'une des revendications 8 ou 9, dans lequel le module (2) à semi-conducteur a au moins deux circuits série d'interrupteurs (52) à semi-conducteur et a au moins quatre bornes (51) de tension continue.

11. Utilisation d'un dispositif (1) de rails conducteurs suivant l'une des revendications 1 à 7, pour connecter au moins un module (2) à semi-conducteur à au moins un condensateur (4), notamment d'un convertisseur.
